# EUROPEAN PATENT APPLICATION

(11) **EP 2 390 012 A2**
(43) Date of publication of application: **30.11.2011**
(21) Application number: 11173840.7
(22) Date of filing: 17.07.2008
(51) Int. Cl.: B05D 7/24, C23C 16/44, C23C 16/50, C23C 16/54, H01J 37/32, C23C 16/507

(54) **Plasma Deposition Apparatus**

(30) Priority: 17.07.2007 GB 0713821
(62) Divisional of application: 08775971.8
(71) Applicant: P2I LTD, Abingdon, Oxfordshire OX14 4SA (GB)
(72) Inventor: Coulson, Stephen Richard, Abingdon, Oxfordshire OX14 4SA (GB); King, Charles Edmund, Abingdon, Oxfordshire OX14 4SA (GB)
(74) Representative: Brewster, Andrea Ruth

(57) **Abstract**

Apparatus for coating a surface of an article with a thin film polymer layer by plasma deposition, comprising (i) a plurality of processing chambers into which articles can be placed; (ii) means for supplying, to the processing chambers, a species capable of being formed into a plasma; (iii) a plasma forming means operable to establish an electrical field internally of the processing chambers so as to form a plasma when said species is supplied thereto; (iv) means for providing a time varying electric current to the plasma forming means; and (v) pressure varying means for selectively controlling pressure in said processing chambers such that pressure in any one or more of said chambers can be controlled independently of pressure in another of said chambers, wherein the processing chambers are supported for movement between a loading or unloading position and a processing position.

## Description

### Background of the Invention

This invention relates to apparatus for nano-coating a surface of an article with a thin film polymer layer by plasma deposition.

### Prior Art

Plasma chambers are known hereto particularly in the processing of semiconductor wafers. Typically, the plasma chambers of such a processing system are made from metals such as stainless steel or aluminium. Internal capacitive plates are generally employed to create the discharge in order to maximise the delivered power into the system whilst minimising losses and maximising the amount of product that can be loaded at any one time. One such arrangement is disclosed in published International Patent Application WO-A-2005/089961.

US Patent US 5,647,913 describes a method of using a capacitive plate set-up to clean away material adhering to internal walls of the plasma reactor. Another description US Patent Application 2007/0034156 uses ion guide apparatus that is enclosed by the deposition chamber and contains an aperture through the deposition vacuum chamber for introducing ionized molecules from a source.

Inductively coupled plasmas have also been used, at low pressure, in order to achieve some degree of surface modification, generally through etching, activation or deposition, such as that described in US Patent US 5,683,548. Other processes described in the literature include the formation of nano-powders (US Patent Application 2005/0258766), amorphous carbon films at high temperature (US 6,423,384) and the decomposition treatment of certain fluorocarbons, as disclosed in Japanese Patent Application JP 10028836.

Further examples describe systems that can carry out partial oxidation reformation of carbonaceous compounds to produce fuel for energy production as disclosed in published International Patent Application WO-A-2004/112447) and continuous production of carbon nano-materials using a high temperature inductively coupled plasma WO-A-2005/007565. In processes where a work piece is being physically or chemically modified then it is highly likely that this work piece will be planar in composition to ensure that homogeneous processing occurs in the time frame required.

The systems described above do not address rapid through-put of plasma enhanced articles, such as textiles or clothing, footwear, medical devices, electronics equipment, or automobile or aerospace parts in three dimensions. In addition they do not describe the attachment of an ultra thin, well adhered polymer layer to a surface of the articles.

Plasma reactions required for semiconductor processing using inductive coil(s) are adapted to create high levels of gas bombardment and fragmentation and operate at parameters inappropriate for tailoring complex 3D products with specific chemical group functionalities that may be supplied through attachment of organic molecules in a controlled manner.

As plasma systems are scaled up to larger volumes to accommodate more product, the total amount of water vapour and/or solvents out-gassing delays the time to reach the desired operating pressure and conditions, leading to longer through-put times and lower rate annual production volumes per piece of equipment. In addition the overall processing time may increase dramatically depending on the proximity of the article to the source generating the activated species required to give the desired technical effect.

### Summary of the Invention

According to the present invention there is provided an apparatus for coating a surface of an article with a thin film polymer layer by plasma deposition, the apparatus comprising:
at least one processing chamber into which one or more articles can be placed;
means for supplying a species to said at least one processing chamber said species being capable of being formed into a plasma;
a plasma forming means associated with the processing chamber for establishing an electrical field suitable for forming a plasma in said chamber, the plasma forming means being operable to establish an electrical field internally of an associated processing chamber for forming a plasma when said species is supplied thereto so that a surface of said article can be coated with a thin film polymer layer by plasma deposition;
means for providing a time varying electric current to the plasma forming means; and
pressure varying means for selectively controlling pressure in said processing chambers such that pressure in any one or more of said chambers can be controlled independently of pressure in another of said chambers.

Ideally the plasma forming means includes an induction device operable to induce an electrical field internally of the processing chamber.

Alternatively, or in addition to the induction device, the plasma forming means includes a capacitive device arranged to form an electrical field internally of an associated processing chamber for forming a plasma.

Preferably the coating is a thin layer, of the order of a few or a few tens of nanometres in thickness, typically up to 100-200 nanometres thick. Such coating is hereinafter referred to as nano-coating.

Other preferred and/or optional features of the invention are defined in the accompanying claims.

The invention will now be described, by way of example only, with reference to the accompanying drawings, in which:-

### Brief Description of the Drawings

Figure 1 is a schematic representation of an apparatus for nano-coating a surface of an article with a thin film polymer layer by plasma deposition;
Figure 2 is a representation of a processing chamber of the apparatus of Figure 1;
Figure 3 is a schematic representation of another apparatus for nano-coating a surface of an article with a thin film polymer layer by plasma deposition; and
Figure 4 is a schematic representation of a still further apparatus for coating a surface of an article with a nano thin film polymer layer by plasma deposition.

### Detailed Description of the illustrated embodiments

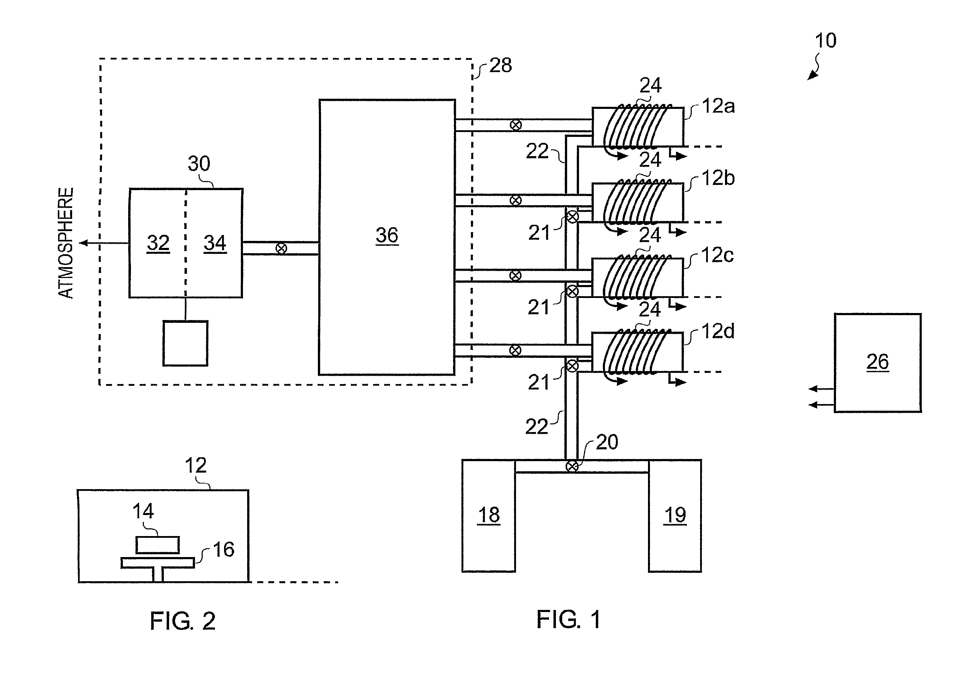

Referring to Figures 1 and 2, an apparatus 10 is shown for coating a surface of an article with a thin film polymer layer by plasma deposition. The apparatus 10 comprises a plurality of processing chambers 12 (12a, 12b, 12c... 12n) into each of which one or more articles 14 can be placed.

Without limitation, such articles may be textiles or clothing, footwear, medical devices, electronic equipment, batteries, filters and filtration equipment (such as air filters), micro or nano devices or automobile or aerospace parts.

The nano thin film polymer layer may produce any desired or advantageous technical effect such as to render the article hydrophobic or oleophobic.

As shown in more detail in Figure 2, the article 14 is placed on a jig 16 in chamber 12 so that the article can be orientated within the chamber so that effective deposition on the article can take place or so that the article can be moved into multiple orientations during processing to effectively nano-coat all of its surfaces. A closure for each chamber is shown in broken lines in the Figures.

The apparatus 10 comprises means for supplying an active species to said processing chambers for forming a plasma in said chambers. The active species is typically a monomer, stored in monomer tube 18, which undergoes polymerisation on a surface of the article when the monomer breaks down and forms a plasma. The monomer is gaseous and stored under pressure in tube 18 such that on operation of valve 20 the monomer passes along ducts 22 and into the processing chambers 12. Valves 21 are operable for selectively supplying gas to any one or more of the processing chambers 12. A carrier gas is stored in tube 19 for delivering the monomer to the processing chambers.

A plurality of induction means 24 are associated with respective processing chambers 12, each induction means being operable to induce an electrical field internally of an associated processing chamber for forming a plasma when the active species is supplied thereto so that a surface of the article can be coated with a thin film polymer layer by plasma deposition.

A control means 26 controls operation of the induction means. Control means 26 comprises means for providing a time varying electric current in the induction means 24. Preferably, the control means 26 further comprises an L-C or suitable matching unit and a power meter which is used to couple the output of a 13.56 MHz RF generator connected to a power supply. This arrangement ensures that the standing wave ratio (SWR) of the transmitted power to partially ionised gas in the processing chamber can be minimised. For pulsed plasma deposition, a pulsed signal generator can be used.

In the arrangement shown in Figure 1, each induction means 24 comprises a coil of electrically conducting material, such as copper in the form of a wire or tube. The ends of the copper are connected to the control means 26 as shown by arrows in the Figure. In an advantageous arrangement, the induction means may each have a wireless connection to the control means 26.

The walls of the processing chamber can be made from a dielectric material. Quartz or borosilicate glass are suitable and inexpensive dielectric materials. The coil can be external to the processing chambers 12 formed by winding a copper conductor around a chamber. In an alternative, coils may be embedded in the wall of the processing chambers or provided internal to the chambers, although this latter configuration is not currently preferred because it hampers cleaning. The processing chambers may be made from a metallic material in which case the inductive coil configuration is likely to be inside of the chamber and is arranged so that, in use, it provides a magnetic field within the major volume of the chamber. Such inductive coils may be singular as in a solenoid, paired as in Helmholtz configuration or have odd or even higher multiples. Coils may be of circular or rectangular cross-section, of vertical or horizontal aspect as appropriate to the chamber shape.

Apparatus 10 further comprises pressure control means 28 for selectively controlling pressure in the processing chambers 12 such that pressure in any one or more of the chambers can be controlled independently of pressure in any other of the chambers. Accordingly, the apparatus can be controlled so that, for instance, the pressure in chamber 12a is at atmosphere while the pressure in chamber 12b is at a processing pressure and the pressure in chamber 12c is being decreased from atmosphere to a processing pressure. The pressure control means 28 can also control pressure in the chambers so that processing steps in different chambers that require different pressure can be performed.

Typically, the pressure that is required for plasma deposition is in the range of 1x10⁻⁵ to 1 torr (approximately 1x10⁻⁸ to 1x10⁻³ bar), however, pressures outside this typical range may be required.

The pressure control means 28 preferably comprises vacuum pumping means 30 which can be selectively placed in fluid communication with said processing chambers so that chambers 12 can be evacuated independently one from another. Although a single pumping unit can be selected to achieve typical processing pressures, it is preferred that the vacuum pumping means 30 comprises a high pressure pumping, or backing unit 32 for reducing pressure from atmosphere to a first, or intermediate, pressure and low pressure pumping unit 34 for reducing pressure from the first pressure to a processing pressure.

The high pressure pumping unit 32 may suitably be a roots pump. The low pressure pumping unit 34 may suitably be a turbo molecular pump. The outlet of such a low pressure pumping unit is not normally capable of exhausting to atmosphere and therefore the outlet is connected to the inlet of the high pressure pumping unit. Ordinarily therefore, the low pressure pumping unit 34 is not activated until pressure in the low pressure pumping unit has been reduced to an intermediate pressure by the high pressure pumping unit 32.

The pressure control means 28 may comprise a pre-evacuation chamber, or pressure sink, 36 connected in series with the vacuum pumping means 30 and the processing chambers 12. Therefore, the pre-evacuation chamber can be maintained at a pressure lower than atmosphere, and preferably lower than a processing pressure, by the vacuum pumping means so that on fluid communication between the pre-evacuation chamber and any one or more of the processing chambers, the pressure in that or those processing chambers is reduced.

In more detail, an internal volume of the pre-evacuation chamber 36 is preferably greater than an internal volume of any of said processing chambers 12. When the pre-evacuation chamber has been evacuated to a low pressure and a path for fluid flow is opened between a processing chamber 12 and the pre-evacuation chamber, the pressure gradient causes evacuation in the processing chamber. Since the volume of the pre-evacuation chamber is relatively large, the rate of pressure reduction in the processing chamber is relatively greater than the rate of pressure increase in the pre-evacuation chamber. In this way, the pressure in the processing chambers can be quickly reduced from atmosphere to a processing pressure when loaded with an article, thus reducing the time taken to process articles.

Advantageously, a plurality of pre-evacuation chambers 36 may be connected in series with the vacuum pumping means 30 and the processing chambers 12. The pre-evacuation chambers 36 can be selectively placed in fluid communication with one or more of said processing chambers so that any one of said pre-evacuation chambers can reduce pressure in any one of said processing chambers. In this way, one pre-evacuation chamber 36 can be used to evacuate a processing chamber 12 when another pre-evacuation chamber is being evacuated by the vacuum pumping means 30. The number of pre-evacuation chambers which may be selected is a function of, inter alia, the processing pressure, the number of processing chambers and the time taken to process an article.

In an alternative arrangement of the pressure control means 28, not shown in the Figures, a high pressure pumping unit is operable for reducing pressure in a pre-evacuation chamber and plurality of low pressure pumping units are connected between respective processing chambers 12 and the pre-evacuation chamber for selectively increasing a pressure differential between one or more of the processing chambers and the pre-evacuation chamber. Such an arrangement may be preferred so that it is not required to maintain the pre-evacuation chamber shown in the Figures at very low processing pressures, but instead the pre-evacuation chamber is evacuated to an intermediate pressure which is more readily or more efficiently maintained.

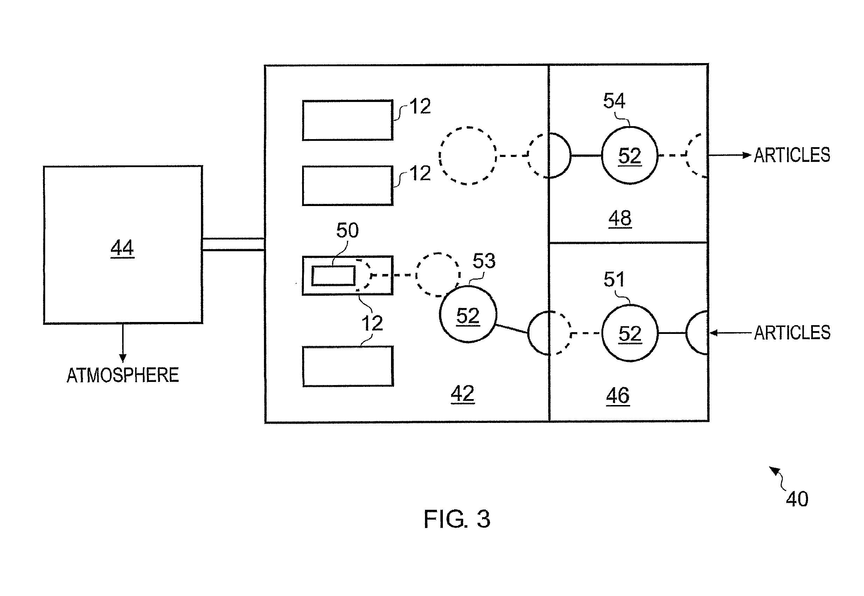

Figure 3 shows an alternative apparatus 40 for coating a surface of an article with a thin film polymer layer by plasma deposition. For ease of understanding not all of the structure described above with reference to Figures 1 and 2 is shown in Figure 3 such as the induction means and active species delivery system.

In Figure 3, a plurality of processing chambers 12 are housed in an intermediate chamber 42 adapted to be maintained at a pressure less than atmosphere, and preferably a processing pressure by a vacuum pumping means 44. The apparatus further comprises one or more load lock chambers (two load lock chambers 46, 48 are shown) adapted to cycle between atmospheric pressure and a pressure of the intermediate chamber to allow articles 50 to be transferred from outside the apparatus to the intermediate chamber without increasing a pressure in the intermediate chamber. This arrangement is advantageous in that it eliminates the requirement to decrease pressure in the processing chambers after placement of an article. Therefore the time taken for pressure reduction and the additional power consumption can be avoided thus increasing the through-put of articles.

Robotic means 52 are required and are operable at a pressure less than atmosphere for transferring articles 50 from a load lock chamber 46 to a processing chamber 12 and for transferring articles to another load lock chamber 48 after processing. The robotic means 52 are shown in broken lines to indicate a range of required movement. Three robots are shown in Figure 3. A first robot 51 transfers articles from atmosphere to the intermediate chamber 42 and is housed in the first load lock chamber 46. A second robot 53 transfers articles to and from the processing chambers 12 and is moveable within the intermediate chamber. A third robot 54 transfers processed articles from the intermediate chamber to atmosphere and is housed in the second load lock chamber 48.

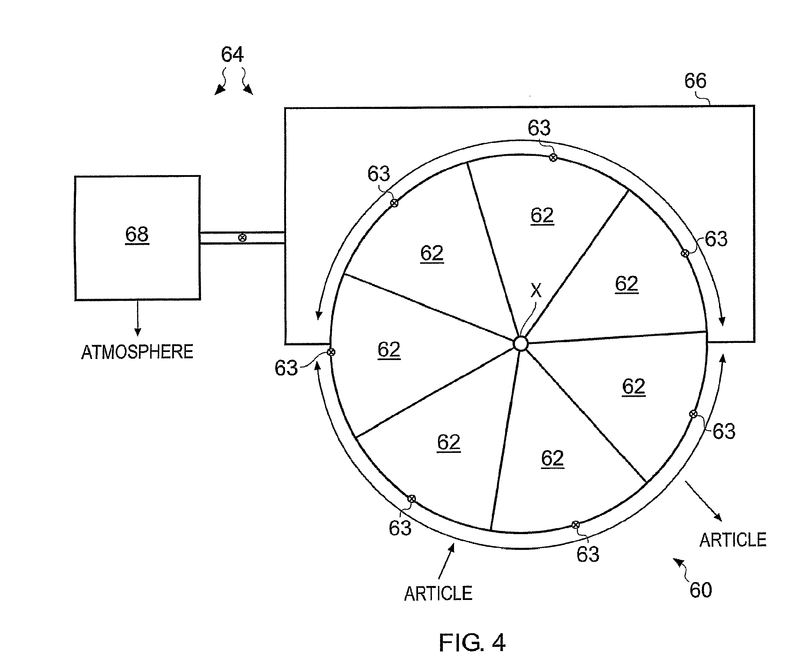

Another arrangement of an apparatus 60 for coating a surface of an article with a thin film polymer layer by plasma deposition is shown in Figure 4. For ease of understanding not all of the structure described above with reference to Figures 1 and 2, or Figure 3 is shown in Figure 4 such as the induction means and active species delivery system.

A plurality of processing chambers 62 are supported for movement between a loading or unloading position and processing position. The processing chambers 62 are supported for rotational movement on a base (not shown in the plan view of Figure 4) about an axis X. Movement is controlled by a motor (also not shown).

In a loading or unloading position, the processing chambers 62 are adapted to be maintained at a pressure higher than a processing pressure (which may be atmosphere) and in a processing position are adapted to be maintained at a processing pressure. The loading/unloading position is shown by the solid arrow in Figure 4, whereas the processing position is shown by the broken arrow. The passage of gas into and out of the chamber is preferably controlled by appropriate valves 63. These valves may be one way valves. A pressure control means 64 comprises a vacuum chamber 66 and vacuum pumping unit 68 for evacuating the vacuum chamber 66 to a processing pressure.

Movement of processing chambers 62 between a loading or unloading position and a processing position automatically initiates pressure reduction in a processing chamber to said processing pressure. Each processing chamber may be fitted with a one way valve 63 allowing gas to pass out of the chamber so that when the processing chamber is rotated into the vacuum chamber 66 gas is caused to flow through its one way valve into the vacuum chamber. When processing has been completed and a processing chamber is rotated out of the vacuum chamber 66, the chamber can be vented to atmosphere and reloaded with an article.

Use of the apparatus shown in the Figures will now be described with particular reference to Figures 1 and 2, although this application is also relevant to the apparatus shown in Figures 3 and 4.

In Figures 1 and 2, an article 14 is loaded onto a jig 16 in a processing chamber 12 which is evacuated to a processing pressure by the pressure control means 28. Since the pressure control means comprises a pre-evacuation pressure, the pressure in the processing chamber can be reduced relatively rapidly. Pre-treatment gases and vapours may be introduced to the chamber if this is required. Monomer is caused to flow into the relevant processing chamber by use of valves 20 and 21 and an electric current is induced in the monomer gas causing the formation of a plasma. The plasma processing step is continued for between 1 second and 10 minutes (depending on the article being processed). Movement of the article during processing can be controlled by movement of jig 16. On completion of the deposition/treatment step, all gases and vapours are isolated from the chambers which are evacuated to low pressure before venting to atmospheric pressure. The processed article is removed and a new article loaded into the processing chamber 12.

An advantage of the present apparatus is that any of the steps required for processing an article can be performed independently in any one of the processing chambers. For instance, any of loading, evacuation, plasma deposition, cleaning, repair and maintenance steps can be performed in or to any one processing chamber while any of such steps are being performed in another of the processing chambers. Such an arrangement considerably increases potential through-put of the apparatus and limits down-time by allowing preventative maintenance.

With particular reference to the evacuation of processing chambers, a processing chamber is evacuated which results in an increase in pressure in a pre-evacuation chamber. When processing in that processing chamber is being performed, the vacuum pumping means can be operated to reduce pressure in the pre-evacuation chamber so that when it is required for evacuating a further processing chamber the pre-evacuation chamber is at the required pressure. Such an arrangement reduces the time taken to process articles.

Further items that may be coated with a water proof/water repellent coating include: sports equipment, high value fashion items such as fashion accessories, electrical goods, personal electronic devices such as BLUETOOTH (Trade Mark) devices, mobile telephones, pagers, personal digital assistants (PDAs), MP3 devices, electrical cables, compact discs (CDs), laptops and keyboards.

It will be appreciated that the invention may be used in conjunction with a range of different activated species in dependence upon the desired characteristics and properties of the item to be coated, and in order to achieve a desired technical effect.

Thus, for example, an antiseptic species may be introduced in order to provide an antiseptic coating, in or on such items as: bandages, dressings, and emergency medical equipment; specialised items of furniture, bathroom furniture, first aid kits, items of clothing; and medical, surgical and dental devices.

Alternatively a fire retardant species can be introduced in order to provide fire resistant properties to such items as: articles of clothing, leather, fabric materials and covers, paper goods, electrical goods, personal electronic devices such as BLUETOOTH (Trade Mark) devices mobile telephones, pagers, personal digital assistant (PDA), MP3 devices, electronic cables, compact discs (CDs), banknotes and credit cards.

In a yet further embodiment, the species to be introduced is a protein binder which is adapted to be introduced into bone and dental implants in order to promote bone growth and binding of a bone material, thereby enhancing re-growth/repair of broken bones or teeth.

In a further embodiment, the species to be introduced may be an electrically conductive material which is adapted to be introduced into specific areas/regions of the item to be coated.

It will be appreciated that the invention is adapted to coat stitched, seamed, woven or connected fabrics or materials, such as, for example: leathers and shoe uppers with or without a bonded sole.

It is also within the scope of the present invention to multiply coat articles with two or more different species, so as to provide two or more different effects, such as for example imparting waterproof and fireproof properties to an article.

The invention has been described by way of various examples and embodiments, with modifications and alternatives, but having read and understood this description, further embodiments and modifications will be apparent to those skilled in the art. All such embodiments and modifications are intended to fall within the scope of the present invention as defined in the accompanying claims.

### Additional aspects of the invention

An additional aspect of the present invention can provide an apparatus for coating a surface of an article with a thin film polymer layer by plasma deposition, the apparatus comprising:
at least one processing chamber into which one or more articles can be placed;
means for supplying a species to said at least one processing chamber said species being capable of being formed into a plasma;
a plasma forming means associated with the processing chamber being operable to establish an electrical field internally of an associated processing chamber for forming a plasma when said species is supplied thereto so that a surface of said article can be coated with a thin film polymer layer by plasma deposition;
means for providing a time varying electric current to the plasma forming means; and
pressure varying means for selectively controlling pressure in said processing chambers such that pressure in any one or more of said chambers can be controlled independently of pressure in another of said chambers.

The plasma forming means may include an induction device operable to induce an electrical field internally of the processing chamber. The induction device may comprise a coil of electrically conducting material. The coils may be embedded in a wall of respective said processing chambers. The coils may be external to respective processing chambers.

The plasma forming means may include a capacitive device arranged to form an electrical field internally of an associated processing chamber for forming a plasma.

The coating may be for nano-coating a surface of the article.

The processing chambers may be formed from a dielectric material. The processing chambers may be made from a conducting material.

The pressure varying means may comprise vacuum pumping means which can be selectively placed in fluid communication with said processing chambers. Said vacuum pumping means may comprise a high pressure pumping unit for reducing pressure from atmospheric to a first pressure and a low pressure pumping unit for reducing pressure from said first pressure to a processing pressure.

Said pressure control means may comprise a pre-evacuation chamber connected in series with said vacuum pumping means and said processing chambers, such that said pre-evacuation chamber can be maintained at a pressure lower than atmospheric by said vacuum pumping means so that on fluid communication between said pre-evacuation chamber and any one or more of said processing chambers, the pressure in said one or more processing chambers is reduced.

The high pressure pumping unit may be operable for reducing pressure in said pre-evacuation chamber and a plurality of said low pressure pumps may be connected between respective processing chambers and said pre-evacuation chamber for selectively increasing a pressure differential between one or more of said processing chambers and said pre-evacuation chamber.

An internal volume of the pre-evacuation chamber may be greater than an internal volume of any of said processing chambers.

A plurality of pre-evacuation chambers may be connected in series with said vacuum pumping means and said processing chambers. The apparatus may be such that the pre-evacuation chambers can be selectively placed in fluid communication with one or more of said processing chambers so that any one of said pre-evacuation chambers can reduce pressure in any one of said processing chambers.

The plurality of processing chambers may be housed in an intermediate chamber adapted to be maintained at a pressure less than atmospheric by said pressure control means, and the apparatus may further comprise one or more load lock chambers adapted to cycle between atmospheric pressure and a pressure of said intermediate chamber to allow articles to be transferred from outside said apparatus to said intermediate chamber without increasing a pressure in said intermediate chamber.

The apparatus may comprise robotic means operable at a pressure less than atmospheric for transferring articles from said one or more load lock chambers to said processing chambers and for transferring articles to said one or more load lock chambers after processing.

The plurality of processing chambers may be supported for movement between a loading or unloading position and a processing position. The apparatus may be such that in a loading or unloading position the processing chambers are adapted to be maintained at a pressure higher than a processing pressure and in a processing position are adapted to be maintained at a processing pressure. It may be such that movement of said processing chambers between a loading or unloading position and a processing position automatically initiates pressure reduction in a said processing chamber to said processing pressure. The processing chambers may be supported for rotational movement on a base about an axis.

The apparatus may be provided with means to effect molecular rearrangement thereby producing new surface properties of the article being coated.

A further aspect of the invention can provide a method for coating a surface of an article with a thin film polymer layer by plasma deposition, including the use of an apparatus according to the invention. A yet further aspect can provide an item coated in accordance with such a method.

## Claims

1. An apparatus for coating a surface of an article with a thin film polymer layer by plasma deposition, the apparatus comprising:
(i) a plurality of processing chambers into which one or more articles can be placed;
(ii) means for supplying a species to the processing chambers, said species being capable of being formed into a plasma;
(iii) a plasma forming means associated with the processing chambers, the plasma forming means being operable to establish an electrical field internally of the processing chambers so as to form a plasma when said species is supplied thereto so that a surface of said article can be coated with a thin film polymer layer by plasma deposition;
(iv) means for providing a time varying electric current to the plasma forming means; and
(v) pressure varying means for selectively controlling pressure in said processing chambers such that pressure in any one or more of said chambers can be controlled independently of pressure in another of said chambers,
wherein said plurality of processing chambers are supported for movement between a loading or unloading position and a processing position.

2. An apparatus according to claim 1, wherein in a loading or unloading position the processing chambers are adapted to be maintained at a pressure higher than a processing pressure and in a processing position are adapted to be maintained at a processing pressure.

3. An apparatus according to claim 2, wherein movement of a processing chamber between a loading or unloading position and a processing position automatically initiates pressure reduction in the processing chamber to said processing pressure.

4. An apparatus according to any one of the preceding claims, wherein the plasma forming means includes an induction device operable to induce an electrical field internally of the processing chambers.

5. An apparatus according to any one of claims 1 to 3, wherein the plasma forming means includes a capacitive device arranged to form an electrical field internally of the processing chambers.

6. Apparatus according to claim 4, wherein said induction device comprises a coil of electrically conducting material.

7. Apparatus according to claim 6, wherein said coil is external to the processing chambers.

8. Apparatus according to any one of the preceding claims, wherein said processing chambers are formed from a dielectric material.

9. Apparatus according to any of the preceding claims, wherein the pressure varying means comprises vacuum pumping means which can be selectively placed in fluid communication with said processing chambers.

10. Apparatus according to claim 9, wherein said pressure control means comprises a pre-evacuation chamber connected in series with said vacuum pumping means and said processing chambers, such that said pre-evacuation chamber can be maintained at a pressure lower than atmosphere by said vacuum pumping means so that on fluid communication between said pre-evacuation chamber and any one or more of said processing chambers, the pressure in said one or more processing chambers is reduced.

11. Apparatus according to claim 10, wherein an internal volume of said pre-evacuation chamber is greater than an internal volume of any of said processing chambers.

12. Apparatus according to claim 10 or claim 11, wherein a plurality of pre-evacuation chambers are connected in series with said vacuum pumping means and said processing chambers.

13. Apparatus according to any one of claims 10 to 12, wherein said pre-evacuation chambers can be selectively placed in fluid communication with one or more of said processing chambers so that any one of said pre-evacuation chambers can reduce pressure in any one of said processing chambers.

14. Apparatus according to any one of the preceding claims, wherein said plurality of processing chambers are housed in an intermediate chamber adapted to be maintained at a pressure less than atmosphere by said pressure control means, said apparatus further comprising one or more load lock chambers adapted to cycle between atmospheric pressure and a pressure of said intermediate chamber to allow articles to be transferred from outside said apparatus to said intermediate chamber without increasing a pressure in said intermediate chamber.

15. Apparatus according to any one of the preceding claims, wherein said processing chambers are supported for rotational movement on a base about an axis.
